# EUROPÄISCHE PATENTANMELDUNG

(11) **EP 2 187 718 A1**
(43) Veröffentlichungstag der Anmeldung: **19.05.2010**
(21) Anmeldenummer: 09013390.1
(22) Anmeldetag: 23.10.2009
(51) Int. Cl.: H05K 3/28

(54) **Elektrischer Antrieb mit einer Leiterplatte**

(30) Priorität: 13.11.2008 DE 102008057154
(71) Anmelder: Bühler Motor GmbH, 90459 Nürnberg (DE)
(72) Erfinder: Kellermann, Helmut, 90579 Langenzenn (DE)

(57) **Zusammenfassung**

Die Erfindung betrifft einen elektrischen Antrieb (1) mit einer Leiterplatte (2), die Leiterbahnen (3) und Kontaktdurchbrüche (4) mit Durchkontaktierungen (5) aufweist und mit elektronischen Bauteilen (6) bestückt ist, wobei die Leiterplatte (2) mit einer Schutzschicht (7) aus isolierendem Material beschichtet ist und Einpresskontakte (8) in die Kontaktdurchbrüche (4) eingepresst sind und in elektrischen Kontaktbereichen (9) innerhalb der Kontaktdurchbrüche (4) elektrischer Kontakt zwischen einem Einpresskontakt (8) und der Durchkontaktierung (5) des Kontaktdurchbruchs (4) besteht. Aufgabe der Erfindung ist es Leiterplatten von elektrischen Antrieben, die Feuchtigkeit und anderen chemischen Umwelteinflüssen ausgesetzt sind, zuverlässig zu schützen und dennoch wirtschaftlich zu kontaktieren. Diese Aufgabe wird erfindungsgemäß dadurch gelöst, dass die Schutzschicht (7) eine Parylene-Beschichtung ist, welche die Leiterplatte (2), die elektronischen Bauteile (6) und die unmittelbar an die Kontaktbereiche (9) zwischen zumindest einem Einpresskontakt (8) und zumindest einem Kontaktdurchbruch (4) anschließenden Oberflächenbereiche der Kontaktdurchbrüche (4) und der Leiterplatte (2) abdeckt.

## Beschreibung

Die Erfindung betrifft einen elektrischen Antrieb (1) mit einer Leiterplatte (2), die Leiterbahnen (3) und Kontaktdurchbrüche (4) mit Durchkontaktierungen (5) aufweist und mit elektronischen Bauteilen (6) bestückt ist, wobei die Leiterplatte (2) mit einer Schutzschicht (7) aus isolierendem Material beschichtet ist und Einpresskontakte (8) in die Kontaktdurchbrüche (4) eingepresst sind und in elektrischen Kontaktbereichen (9) innerhalb der Kontaktdurchbrüche (4) elektrischer Kontakt zwischen einem Einpresskontakt (8) und der Durchkontaktierung (5) des Kontaktdurchbruchs (4) besteht.

Der Schutz von Leiterplatten mittels Parylene-Überzug hat sich als hydrophobe, chemisch resistente Barriere gegenüber anorganischen und organischen Medien, starken Säuren, Laugen, Gasen und Wasserdampf bewährt. Parylene sind ein hervorragender elektrischer Isolator mit hoher Spannungsfestigkeit und niedriger Dielektrizitätskonstante. Sie wird als porenfreier und transparenter Polymerfilm prozessbedingt im Vakuum durch Kondensation aus der Gasphase (CVD-Prozess / Chemical Vapour Deposition) auf das Substrat aufgebracht. Dieser Prozess hat zur Folge, dass der Polymerüberzug die Leiterplatte vollständig umgibt, wodurch eine anschließende elektrische Kontaktierung bisher nur nach weiteren Bearbeitungsschritten möglich schien. Nach dem Stand der Technik werden Kontaktierungsstellen bisher durch Aufbringung eines Maskierungsmaterials vor dem CVD-Prozess geschützt. Alternativ kann die Parylene-Beschichtung partiell mittels Laserstrahl oder auch mechanisch abgetragen werden. Diese zusätzlichen Arbeitsschritte erhöhen den Fertigungsaufwand und vergrößern die Fertigungsrisiken.

Als wirtschaftliche Kontaktierungsmöglichkeit für unbeschichtete Leiterplatten hat sich die Einpresskontaktierung etabliert. Dabei werden handelsübliche Einpresskontakte durch einen einfachen Einpressvorgang in durchkontaktierte Kontaktdurchbrüche eingepresst und bilden dadurch eine dauerhafte sichere Kontaktierung ohne zusätzliche Löt- oder Schweißvorgänge.

Aufgabe der Erfindung ist es Leiterplatten von elektrischen Antrieben, die Feuchtigkeit und anderen chemischen Umwelteinflüssen ausgesetzt sind, zuverlässig zu schützen und dennoch wirtschaftlich zu kontaktieren.

Diese Aufgabe wird erfindungsgemäß durch das Kennzeichen des gegenständlichen Anspruchs 1 und durch das Verfahren gemäß Anspruch 9 gelöst.

Parylene schützt die Leiterplatte durch eine sehr dünne Schicht, welche die mechanischen Eigenschaften und die Abmessungen der Leiterplatte kaum beeinträchtigt. In einem Arbeitsgang können Schichtdicken von 0,1 bis 50 Mikrometer aufgebracht werden. Da das Material aus der Gasphase direkt in die feste Phase überführt wird kommt es nicht zu Meniskusbildungen an scharfen Rändern, Spitzen, engen und tiefen Spalten oder an elektrischen Bauteilen. Da die Leiterplatte vollumfänglich beschichtet ist, können die Abstände zwischen den Bauteilen und den Leiterbahnen enger gewählt werden als bei unbeschichteten Leiterplatten, dies gilt insbesondere auch für die Bereiche in denen die Leiterplatte kontaktiert wird. Maskierungen oder Nachbearbeitungen hätten ungeschützte Bereiche auf der Leiterplatte zwischen den Kontakten zur Folge, wodurch die Zuverlässigkeit eingeschränkt und die Gefahr von Dendritenbildung gegeben wäre. Dendriten entstehen durch elektrochemische Vorgänge und führen bei fortschreitendem Dendritenwachstum zu Kurzschlüssen. Durch die erfindungsgemäße Lösung sind tatsächlich nur die Bereiche der Leiterplatte ungeschützt die unmittelbar als Kontaktbereiche dienen und von den Einpresskontakten überdeckt werden.

Weiterbildungen der Erfindung werden durch die Unteransprüche dargestellt. Als besonders geeignet hat sich Parylene D (z.B. Poly-para-di-chloro-Xylylen) herausgestellt.

Ausführungsbeispiele der Erfindung werden nachfolgend anhand der Zeichnung näher erläutert. Es zeigen:
- Fig. 1: eine Schnittansicht einer bestückten und beschichteten Leiterplatte,
- Fig. 2: die Leiterplatte mit montiertem Einpresskontakt,
- Fig. 3: eine Draufsicht auf eine Leiterplatte und
- Fig. 4: eine Schnittansicht durch einen elektrischen Antrieb mit einer Leiterplatte.

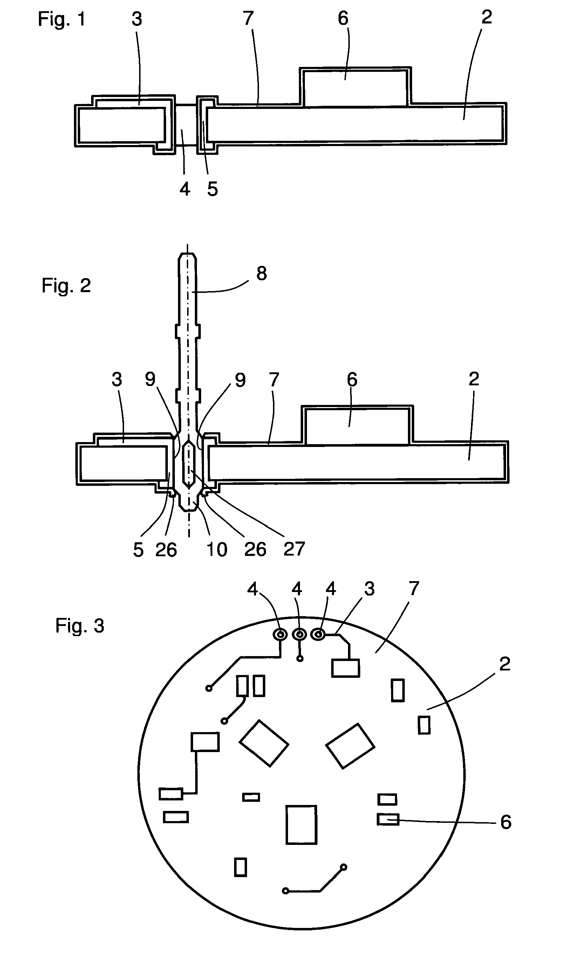

Fig. 1 zeigt eine Schnittansicht einer mit elektrischen Bauteilen 6 bestückten mit einer Schutzschicht 7 aus Parylene-Material überzogenen Leiterplatte 2. Die Beschichtung schließt auch einen Kontaktdurchbruch 5 mit Durchkontaktierung 4, sowie Leiterbahnen 3 ein. Bei den elektronischen Bauteilen handelt es sich vorwiegend um SMD-Bauteile. Im gezeigten stilisierten Beispiel ist die gesamte Leiterplatte 2 lückenlos mit der Parylene-Beschichtung überzogen. Die Erfindung umfasst auch Leiterplatten, die aus anderen Gründen an definierten Bereichen nicht beschichtet sind.

Fig. 2 zeigt die Leiterplatte 2 mit einem montierten Einpresskontakt 8. Der Einpresskontakt 8 weist an seinem Ende eine Fügehilfe auf, deren Durchmesser kleiner als der Durchmesser im Kontaktbereich 9 ist. Der Einpresskontakt 8 ist im Kontaktbereich 9 so dimensioniert, dass eine Pressverbindung auch ohne Beschichtung gegeben wäre. Der Einpresskontakt 8 ist im Kontaktbereich 9 so ausgebildet, dass die Parylenebeschichtung an dieser Stelle aufgetrennt wurde und somit eine sichere elektrische Verbindung zwischen dem Einpresskontakt 8 und der Durchkontaktierung 5 gewährleistet ist. Die Beschichtung ist teilweise aus dem Kontaktbereich verdrängt. In Fig. 2 ist die verdrängte Beschichtung 26 deutlich zu erkennen. Im gezeigten Beispiel handelt es sich bei der Beschichtung um ein Parylene D - Material, das eine größere Sprödigkeit als z.B. Parylene C aufweist. Durch die größere Sprödigkeit wird die Auftrennung im Kontaktbereich erleichtert. Diese Auftrennung der Parylene-Beschichtung wird mit handelsüblichen Einpresskontakten erreicht. Es handelt sich dabei in der Regel um Stanzteile, welche kantig ausgebildet sind. Die Parylene-Beschichtung lässt sich auch mit weniger scharfkantigen Einpresskontakten aus dem Kontaktbereich verdrängen. Der Einpresskontakt 8 weist im Abschnitt der Kontaktbereiche 9 einen Freiraum 27 auf, der ein geringfügiges Ausweichen des Einpresskontakts 8 beim Fügen erlaubt.

Fig. 3 zeigt eine Draufsicht auf eine mit einer Schutzschicht 7 versehenen Leiterplatte 2 mit elektrischen Bauteilen 6, Leiterbahnen 3 und Kontaktdurchbrüchen 4.

Die Leiterplatte 2 ist in den Fig. 1 bis 3 als einseitig bestückte Leiterplatte dargestellt. Die Erfindung umfasst jedoch auch Leiterplatten, die zweiseitig bestückt und mit Leiterbahnen versehen sind und auch Multilayer-Leiterplatten.

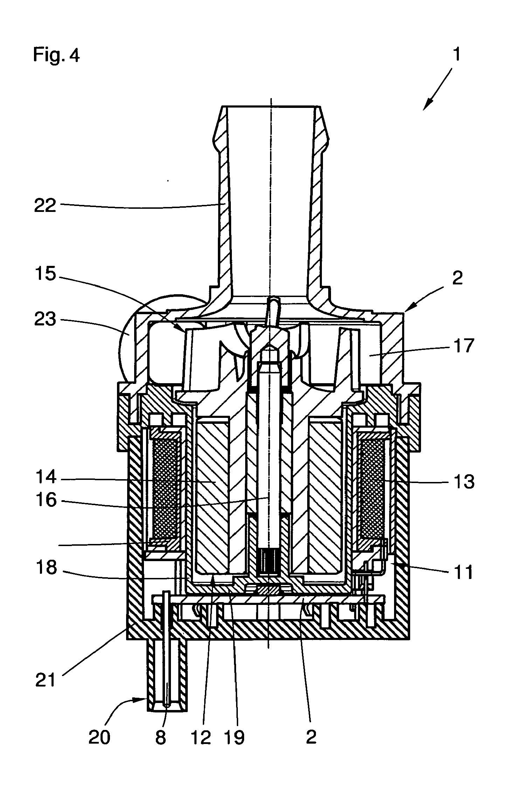

Fig. 4 zeigt eine Schnittansicht durch einen elektrischen Antrieb mit einer Leiterplatte 2. Der elektrische Antrieb ist hier eine Kreiselpumpe die von einem elektronisch kommutierten Gleichstrommotor mit einem Stator 11 und einem Rotor 12 angetrieben wird. Der Stator 11 umfasst eine elektrische Wicklung 13 und der Rotor 12 einen Permanentmagneten 14. Der Rotor ist mit einem Pumpenlaufrad 15 einstückig und auf einer Achse 16 drehbar gelagert.

Der Rotor 12 befindet sich im Nassbereich 17 der Kreiselpumpe. Der Nassbereich 17 ist durch einen Spalttopf 18 vom Stator 11 und einer Leiterplatte 2 getrennt. Die Leiterplatte 2 ist elektrisch mit der Wicklung 13 verbunden und liegt großflächig über ein Wärmeleitpad an einem Topfboden 19 des Spalttopfs 18 an. Die dünne Parylene-Beschichtung hat hier auch den Vorteil, dass sie die Wärmeleitung zum Nassraum hin wegen ihres geringen thermischen Widerstandes nur sehr wenig beeinträchtigt. Die Leiterplatte 2 ist mit einem Einpresskontakt 8 versehen, der Teil eines Anschlusssteckers 20 ist. Der Anschlussstecker 20 ist mit einem Motorgehäuse 21 einstückig. Die Kreiselpumpe umfasst einen Saugstutzen 22 und einen Druckstutzen 23. Der Saugstutzen 22 und der Druckstutzen 23 sind mit einem Pumpenkopf 24 einstückig. Der Spalttopf 18 ist pumpenseitig mit einem sich radial nach außen erweiternden Flansch 25 versehen, der zwischen Pumpenkopf 24 und Motorgehäuse 21 sandwichartig angeordnet ist und an ihren Verbindungsbereichen verschweißt. Die Einpresskontakte 8 werden erst nach der Montage der Leiterplatte 2 und des Motorgehäuses 21 mit dem Anschlussstecker 20 eingepresst.

### Bezugszeichenliste

- 1: elektrischer Antrieb
- 2: Leiterplatte
- 3: Leiterbahn
- 4: Kontaktdurchbruch
- 5: Durchkontaktierung
- 6: Elektronisches Bauteil
- 7: Schutzschicht
- 8: Einpresskontakt
- 9: Kontaktbereich
- 10: Fügehilfe
- 11: Stator
- 12: Rotor
- 13: Wicklung
- 14: Permanentmagnet
- 15: Pumpenlaufrad
- 16: Achse
- 17: Nassraum
- 18: Spalttopf
- 19: Topfboden
- 20: Anschlussstecker
- 21: Motorgehäuse
- 22: Saugstutzen
- 23: Druckstutzen
- 24: Pumpenkopf
- 25: Flansch
- 26: verdrängte Beschichtung
- 27: Freiraum

## Patentansprüche

1. Elektrischer Antrieb (1) mit einer Leiterplatte (2), die Leiterbahnen (3) und Kontaktdurchbrüche (4) mit Durchkontaktierungen (5) aufweist und mit elektronischen Bauteilen (6) bestückt ist, wobei die Leiterplatte (2) mit einer Schutzschicht (7) aus isolierendem Material beschichtet ist, Einpresskontakte (8) in die Kontaktdurchbrüche (4) eingepresst sind und in elektrischen Kontaktbereichen (9) innerhalb der Kontaktdurchbrüche (4) elektrischer Kontakt zwischen einem Einpresskontakt (8) und der Durchkontaktierung (5) des Kontaktdurchbruchs (4) besteht, **dadurch gekennzeichnet, dass** die Schutzschicht (7) eine Parylene-Beschichtung ist, welche die Leiterplatte (2), die elektronischen Bauteile (6) und die unmittelbar an die Kontaktbereiche (9) zwischen zumindest einem Einpresskontakt (8) und zumindest einem Kontaktdurchbruch (4) anschließenden Oberflächenbereiche der Kontaktdurchbrüche (4) und der Leiterplatte (2) abdeckt.

2. Elektrischer Antrieb nach Anspruch 1, **dadurch gekennzeichnet, dass** die Schutzschicht (7) in dem Kontaktbereich (9) durch den Einpresskontakt (8) aufgetrennt ist.

3. Elektrischer Antrieb nach Anspruch 1 oder 2, **dadurch gekennzeichnet, dass** die Schutzschicht (7) aus dem Kontaktbereich (9) durch den Einpresskontakt (8) zumindest teilweise verdrängt ist.

4. Elektrischer Antrieb nach Anspruch 1, 2 oder 3, **dadurch gekennzeichnet, dass** die Schutzschicht (7) eine Parylene D - Beschichtung ist.

5. Elektrischer Antrieb nach Anspruch 1, 2, 3 oder 4, **dadurch gekennzeichnet, dass** die Einpresskontakte (8) nicht mit der Parylene-Beschichtung versehen sind.

6. Elektrischer Antrieb nach Anspruch 1, 2, 3, 4 oder 5, **dadurch gekennzeichnet, dass** die Leiterplatte (2) Bestandteil eines bürstenlosen Gleichstrommotors ist.

7. Elektrischer Antrieb nach Anspruch 6, **dadurch gekennzeichnet, dass** der bürstenlose Gleichstrommotor Bestandteil eines Pumpenantriebs ist.

8. Elektrischer Antrieb nach Anspruch 7, **dadurch gekennzeichnet, dass** der Pumpenantrieb ein Kreiselpumpenantrieb ist.

9. Verfahren zur Herstellung eines elektrischen Antriebs mit einer Leiterplatte (2), die Leiterbahnen (3) und Kontaktdurchbrüche (4) mit Durchkontaktierungen (5) aufweist und mit elektronischen Bauteilen (6) bestückt ist, wobei die Leiterplatte (2) mit einer Schutzschicht (7) aus isolierendem Material beschichtet ist, Einpresskontakte (8) in die Kontaktdurchbrüche (4) eingepresst sind und in elektrischen Kontaktbereichen (9) innerhalb der Kontaktdurchbrüche (4) elektrischer Kontakt zwischen einem Einpresskontakt (8) und der Durchkontaktierung (5) des Kontaktdurchbruchs (4) besteht, **gekennzeichnet durch** folgende Verfahrensschritte: a) Bestücken einer Leiterplatte mit elektronischen Bauteilen, b) Abscheidung von Parylene-Material aus der Gasphase im Vakuum auf die Leiterplatte einschließlich der elektronischen Bauteile und der Kontaktdurchbrüche (4), c) Montage der beschichteten Leiterplatte (2) in den elektrischen Antrieb (1), d) Fügen von Einpresskontakten (8) in den jeweiligen Kontaktdurchbruch (4) unter Auftrennung der Schutzschicht (7) in den Kontaktbereichen (9).
